# EUROPEAN PATENT APPLICATION

(11) **EP 4 539 268 A1**
(43) Date of publication of application: **16.04.2025**
(21) Application number: 23822836.5
(22) Date of filing: 09.05.2023
(51) Int. Cl.: H01S 5/02218, G01S 17/931, G01S 7/484

(54) **CHIP PACKAGING BODY, PHOTOSENSITIVE MODULE, LASER EMITTING MODULE AND LIDAR**

(30) Priority: 13.06.2022 CN 202210659146
(71) Applicant: Focuslight Technologies Inc., Xi'an, Shaanxi 710077 (CN)
(72) Inventor: ZHANG, Hao, Xi'an, Shaanxi 710077 (CN); LI, Yong, Xi'an, Shaanxi 710077 (CN); FAN, Yingmin, Xi'an, Shaanxi 710077 (CN); LIU, Xingsheng, Xi'an, Shaanxi 710077 (CN)
(74) Representative: Carangelo, Pierluigi
(86) International application number: PCT/CN2023/092863
(87) International publication number: WO 2023/241265

(57) **Abstract**

A chip packaging body, a photosensitive module, a laser emitting module and a lidar, relating to the technical field of photoelectric packaging. Directly packaging a photonic bare chip (110) to a circuit board (100) by means of a transparent insulating adhesive (130) can effectively simplify packaging steps and reduce the packaging costs; and a connection between a bonding wire (150) and the photonic bare chip (110) and a connection between the photonic bare chip (110) and the circuit board (100) can also be reinforced by means of the transparent insulating adhesive (130). The transparent insulating adhesive (130) protects the photonic bare chip (110) from coming into contact with external dust and dew, thereby avoiding causing the photonic bare chip (110) to fail. Moreover, directly packaging the photonic bare chip (110) to the circuit board (100) by means of the transparent insulating adhesive (130) can avoid additional parasitic inductance and thermal resistance introduced when the packaged chip is repackaged to the circuit board (100), such that a device can have higher peak light output power and higher electro-optical conversion efficiency, and can satisfy the automotive-grade reliability. The chip packaging body, as a module, can be flexibly integrated into a temperature control system to guarantee smaller performance deviation in high and low temperature environments.

## Description

### Cross-Reference of Related Applications

The invention claims priority to Chinese patent application No. 202210659146.1, filed with the Chinese Patent Office on June 13, 2022, entitled "Chip Package Body, Photosensitive Module, Laser Emitting Module and LiDAR", the entire contents of which are incorporated herein by reference.

### Field of the Disclosure

The invention relates to the field of optoelectronic packaging technology, and specifically to chip package (body), photosensitive module, laser emitting module and lidar.

### Background

With the rapid development of information and control technology, automatic driving technology is gradually accepted by automobile manufacturers and users. Autonomous driving not only minimize the danger of automobile driving, but also reduce the user's heavy driving task, therefore, autonomous driving is the trend of future automobile development. To achieve a higher level of autonomous driving capability, it is necessary to install a variety of sensors on the vehicle, and LiDAR belongs to one of them.

Existing LiDARs installed in automobiles are commonly referred to as vehicle-mounted LiDAR, and in the assembly process, the laser chip is usually first individually packaged for vehicle-grade packaging and the laser chip electrodes inside the packaging structure are drawn out to form the pins, and then the laser chip after the completion of the individual package is mounted on the circuit board as a whole and the pins are connected to the circuit board correspondingly, and this packaging method, on the one hand, will introduce large parasitic inductance and thermal resistance, resulting in the performance of the device being affected. This packaging method, on the one hand, will introduce a large parasitic inductance and thermal resistance, resulting in limited device performance, on the other hand, will make the packaging step more complex, the cost remains high. If the photonic bare chip is directly packaged on the circuit board, although the parasitic inductance and thermal resistance can also be reduced, the photonic bare chip is susceptible to short-term failure due to the influence of dust and water vapor in the external environment, and the reliability is poor.

### Summary

The purpose of this application is to provide a chip package, a photosensitive module, a laser emitting module and lidar to address the deficiencies in the above-mentioned prior art. While simplifying the packaging steps, it can also reduce the parasitic inductance and thermal resistance introduced by the packaging, thereby enhancing the performance of the device, and ensuring a high degree of vehicle specification reliability.

To achieve the above purpose, the technical solution adopted in the embodiment of the invention is as follows.

According to one aspect of an embodiment of the invention, a chip package is provided, comprising a circuit board and a photonic bare chip, wherein the photonic bare chip is arranged on the circuit board, and The photonic bare chip is connected to the drive circuit of the circuit board via bonding wires, so that the drive circuit can drive the photonic bare chip, and a transparent insulating encapsulation colloid, which at least covers the photonic bare chip, is also arranged on the circuit board, and the photonic bare chip has a window for light beam emission or incidence.

Optionally, the transparent insulating encapsulation colloid at least covers the photonic bare chip and the bonding wire.

Optionally, the driving circuit comprises a driver chip, and the photonic bare chip is connected to the driver chip via the bonding wire.

Optionally, the driving circuit comprises a driver chip, and the positive electrode of the photonic bare chip is connected to the driver chip through a bonding wire.

Optionally, the photonic bare chip is directly mounted on the circuit board, or the photonic bare chip is mounted on the circuit board via a substrate.

Optionally, an outer wall surface of the transparent insulating encapsulation colloid corresponding to the window is a planer.

Optionally, an optical shaping portion is provided on the outer wall surface of the transparent insulating encapsulation colloid corresponding to the window to shape the light beam emitted through the window.

Optionally, the optical shaping portion is a convex portion, which is used to collimate the light beam emitted through the window along the fast axis and/or slow axis direction.

Optionally, the light transmittance of the transparent insulating encapsulation colloid is greater than 95%.

Optionally, the transparent insulating encapsulation colloid is set to one of epoxy resin, silicone and thermosetting plastic.

In another aspect of an embodiment of the invention, a photosensitive module is provided, comprising any one of the above-mentioned chip packages, wherein the photonic bare chip of the chip package is a photosensitive chip.

According to another aspect of the embodiments of the invention, a laser emitting module is provided, comprising any one of the above-mentioned chip packages, wherein the photonic bare chip of the chip package is a laser bare chip.

According to another aspect of the embodiments of the invention, a lidar is provided, comprising any one of the lasers emitting modules described above.

The beneficial effect of this application is following.

The invention provides a chip package, a photosensitive module, a laser emitting module and lidar. By encapsulating the photonic bare chip directly onto the circuit board using a transparent insulating encapsulation colloid, the packaging process can be effectively simplified, thereby reducing packaging costs. At the same time, the transparent insulating encapsulation colloid covers the photonic bare chip, providing excellent protection against external dust and moisture, ensuring that the chip package meets high reliability requirements, such as automotive-grade standards. Additionally, the transparent insulating encapsulation colloid not only strengthens the connection between the bare photonic chip and the circuit board but also reinforces the bonding between the bonding wires and the photonic chip, preventing weak bonding or detachment of the bonding wires from the pads on the photonic chip.

This application uses a method of directly packaging the photonic bare chip onto the circuit board with a transparent insulating encapsulation colloid, which avoids the additional parasitic inductance and thermal resistance that are introduced when already packaged chips are repackaged onto the circuit board. In other words, this application effectively reduces parasitic inductance in the circuit, thereby decreasing rise and fall times, which in turn narrows the pulse width, facilitating an increase in pulse peak power. At the same time, it reduces thermal resistance, allowing the device to achieve higher peak optical output power and greater electro-optical conversion efficiency. Additionally, the chip package in this application can be flexibly integrated into a temperature control system as a module, ensuring minimal performance deviation in both high and low-temperature environments.

### Description of Drawings

To illustrate the technical solutions of the embodiments of the invention more clearly, the drawings required for use in the embodiments will be briefly introduced below. The following drawings only show certain embodiments of the invention and therefore should not be regarded as limiting the scope. For those skilled in the art, other related drawings can be obtained based on these drawings without paying creative work.
FIG. 1 is a schematic structural diagram of a chip package provided in an embodiment of the invention.
FIG. 2 is a partial enlarged view of a chip package provided in an embodiment of the invention.
FIG. 3 is one of the schematic diagrams of an unpackaged photonic bare chip provided in an embodiment of the invention.
FIG. 4 is a second schematic diagram of an unpackaged photonic bare chip provided in an embodiment of the invention.
FIG. 5 is a schematic diagram of a chip package after packaging according to an embodiment of the invention.
FIG. 6 is a second schematic diagram of the structure of a chip package after packaging provided by an embodiment of the invention.
FIG. 7 is a schematic diagram of a photonic bare chip provided in an embodiment of the invention as a light emitting chip.
FIG. 8 is a schematic diagram of a photonic bare chip provided in an embodiment of the invention as a photosensitive chip.
FIG. 9 is a top view of a chip package provided in an embodiment of the invention.
FIG. 10 is a schematic diagram of a chip package provided in an embodiment of the invention for collimating a light beam in a fast axis direction.
FIG. 11 is a schematic diagram of a chip package provided in an embodiment of the invention for collimating a light beam in a slow axis direction.

Reference numerals: 100 - circuit board, 110 - photonic bare chip, 111 - substrate, 120 - driver chip, 130 - transparent insulating encapsulation colloid, 131 - convex portion, 140 - electronic components, 150 - bonding wire, 210 - light beam.

### Embodiments

To make the purpose, technical solution, and advantages of the embodiments of the invention clearer, the technical solution in the embodiments of the invention will be clearly and completely described below in conjunction with the drawings in the embodiments of the invention. Obviously, the described embodiments are part of the embodiments of the invention, rather than all the embodiments. The components of the embodiments of the invention described and shown in the drawings here can be arranged and designed in various configurations.

Therefore, the following detailed description of the embodiments of the invention provided in the accompanying drawings is not intended to limit the scope of the invention for protection, but merely represents selected embodiments of the invention. It should be noted that, in the absence of conflict, the various features in the embodiments of the invention can be combined with each other, and the combined embodiments are still within the scope of protection of the invention.

In the description of the invention, it should be noted that the terms "upper", "lower", "left", "right", "inside", "outside", etc. indicate directions or positional relationships based on the directions or positional relationships shown in the accompanying drawings or are directions or positional relationships in which the products of the invention are usually placed when in use. They are only for the convenience of describing the invention and simplifying the description, and do not indicate or imply that the device or element referred to must have a specific direction, be constructed, and operated in a specific direction, and therefore should not be understood as a limitation on the invention.

In the description of this application, it should also be noted that, unless otherwise clearly specified and limited, the terms "set", "install", and "connect" should be understood in a broad sense, for example, it can be a fixed connection, a detachable connection, or an integral connection. It can be a mechanical connection or an electrical connection. It can be a direct connection, or it can be indirectly connected through an intermediate medium, or it can be the internal communication of two elements. For ordinary technicians in this field, the specific meanings of the above terms in this application can be understood according to specific circumstances.

One aspect of an embodiment of the invention provides a chip package, which can avoid the additional parasitic inductance and thermal resistance introduced when the packaged chip is packaged on the circuit board by directly packaging the photonic bare chip on the circuit board, thereby limiting the device performance, while also ensuring the high reliability of the photonic bare chip directly packaged on board. Since the step of individually packaging the bare chip is omitted, the overall packaging steps can also be effectively simplified, reducing the cost of packaging, and helping to improve the packaging yield. The embodiment of the invention is described below in conjunction with the accompanying drawings.

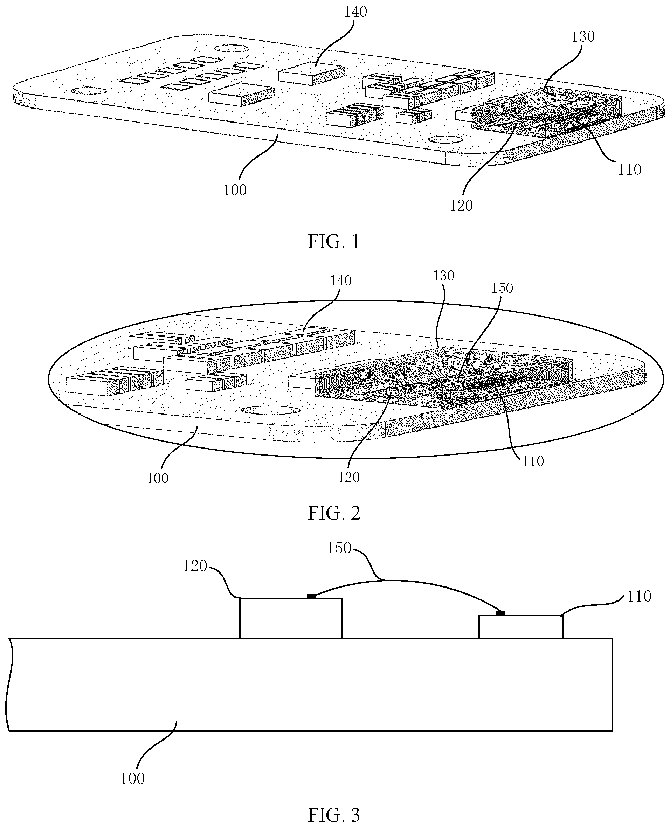

Please refer to Figures 1, 2 and 9, which show the structure of the chip package after packaging. The chip package comprises a circuit board 100 and a photonic bare chip 110. The photonic bare chip 110 is directly packaged on the circuit board 100. Among them, the circuit board 100 has at least a driving function to drive the photonic bare chip 110 to be in a working state. The photonic bare chip 110 in a working state can be light emitting or light sensitive. In some embodiments, the circuit board 100 can be a main board. In other words, as shown in Figures 1 and 2, a variety of electronic components 140 can also be arranged on the circuit board 100. For example, a processor, a memory, a power management module, and a communication module are also arranged on the circuit board 100. The electronic components 140 can be connected as needed according to the lines on the circuit board 100 to achieve corresponding functions.

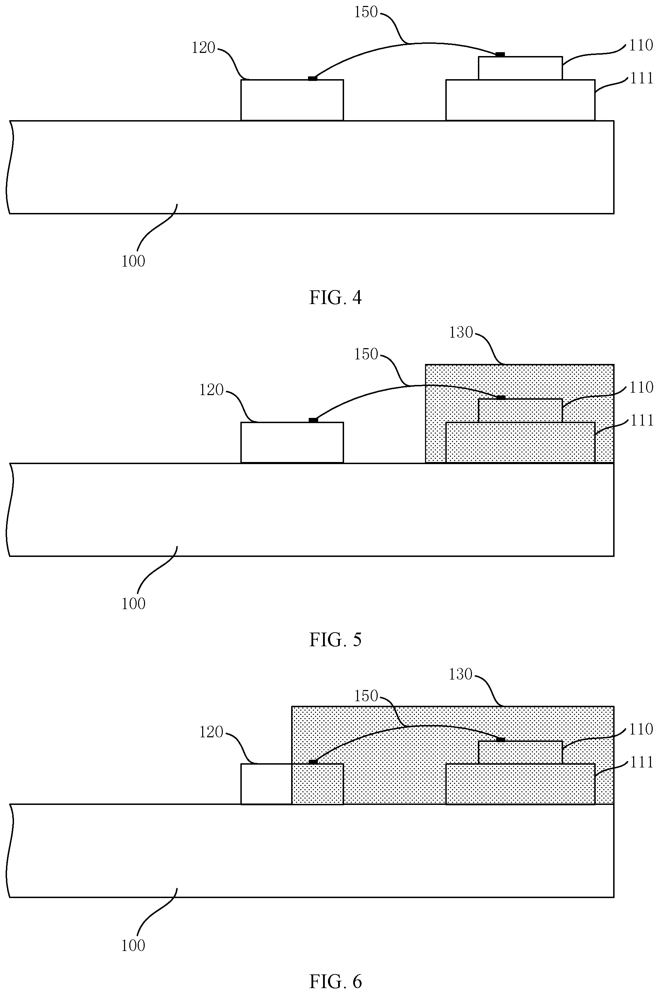

Please refer to FIG. 3 or FIG. 4, which shows a state where the photonic bare chip 110 is disposed of on the circuit board 100 and is not packaged. In one embodiment, the cathode of the photonic bare chip 110 may be located on the bottom surface of the photonic bare chip 110 and connected to the circuit board 100 through a bonding process, and the anode of the photonic bare chip 110 may be located on the top surface of the photonic bare chip 110 and connected to the circuit board 100 through a bonding wire 150, so that the circuit board 100 can directly drive the photonic bare chip 110. In one embodiment, the anode of the photonic bare chip 110 may be located on the bottom surface of the photonic bare chip 110 and connected to the circuit board 100 through a bonding process, and the cathode of the photonic bare chip 110 may be located on the top surface of the photonic bare chip 110 and connected to the circuit board 100 through a bonding wire 150, so that the circuit board 100 can directly drive the photonic bare chip 110.

To realize the circuit board 100 driving the photonic bare chip 110, the circuit board 100 has a driving circuit, and the photonic bare chip 110 is connected to the driving circuit. In one embodiment, referring to Figures 1 to 11, the driving circuit comprises a driver chip 120, and the photonic bare chip 110 is connected to the driver chip 120 through a bonding wire 150.

The type of the circuit board 100 may be a ceramic circuit board 100, an alumina ceramic circuit board 100, an aluminum nitride ceramic circuit board 100, an FR4 circuit board 100, etc. The invention does not limit the type, and the specific selection may be reasonably made according to actual needs.

For example, in one embodiment as shown in FIG. 3, the circuit board 100 is a ceramic circuit board 100. In this case, the photonic bare chip 110 can be directly bonded to the ceramic circuit board 100, and then the photonic bare chip 110 can be connected to the ceramic circuit board 100 via a bonding wire 150.

In another embodiment as shown in FIG. 4, the circuit board 100 is a FR4 circuit board 100. In view of the fact that there may be a mismatch in thermal expansion coefficients between the photonic bare chip 110 and the FR4 circuit board 100, the photonic bare chip 110 can be first set on the substrate 111, and then the substrate 111 with the photonic bare chip 110 can be mounted on the FR4 circuit board 100, forming a structure in which the substrate 111 is located between the photonic bare chip 110 and the circuit board 100 as shown in FIG. 4. In this way, the thermal expansion mismatch between the photonic bare chip 110 and the FR4 circuit board 100 can be balanced by the substrate 111. Similarly, when there is a thermal expansion mismatch between the photonic bare chip 110 and other types of circuit boards 100, this method can be referred to for improvement, which will not be repeated here. It should be noted that when the photonic bare chip 110 has a substrate 111, the negative electrode on the bottom surface of the photonic bare chip 110 can be led out from the back hole on the substrate 111, thereby realizing the connection between the negative electrode of the photonic bare chip 110 and the circuit board 100.

After the photonic bare chip 110 is fixedly arranged on the circuit board 100, referring to FIG. 1 and FIG. 2, a transparent insulating encapsulation colloid 130 may also be arranged on the circuit board 100, and the photonic bare chip 110 is coated by the transparent insulating encapsulation colloid 130, so as to achieve the purpose of directly packaging the photonic bare chip 110 on the circuit board 100. In addition, the photonic bare chip 110 has a window for light beam emission or incidence.

In summary, firstly, the invention can effectively simplify the packaging steps and reduce the packaging cost by at least packaging the photonic bare chip 110 with the transparent insulating encapsulation colloid 130 to directly package it into the circuit board 100. At the same time, the photonic bare chip 110 is covered by the transparent insulating encapsulation colloid 130 to provide good protection for the photonic bare chip 110, so that the photonic bare chip 110 can be protected from the influence of external dust and water vapor, so that the chip package can meet high reliability requirements, such as automotive grade. The transparent insulating encapsulation colloid 130 can not only strengthen the connection between the photonic bare chip 110 and the circuit board 100, but also strengthen the connection between the bonding wire 150 and the photonic bare chip 110, to prevent the bonding wire 150 from falling off due to weak bonding force with the pad on the photonic bare chip 110.

Then, the invention can avoid the additional parasitic inductance and thermal resistance introduced when the packaged chip is packaged on the circuit board by directly packaging the photonic bare chip 110 to the circuit board 100 through the transparent insulating encapsulation colloid 130. In other words, the invention can effectively reduce the parasitic inductance in the loop, thereby reducing the rising edge and falling edge time, and then reducing the pulse width, which is convenient for increasing the peak power of the pulse, and can also reduce the thermal resistance, so that the device can have a higher peak light output power and a greater electro-optical conversion efficiency. In addition, the chip package of the invention can be used as a module and can be flexibly integrated into the temperature control system to ensure a small performance deviation in high and low temperature environments.

In some embodiments, the bonding wire 150 can be a gold wire, a copper wire, a silver wire, etc., and the corresponding connection can be achieved through a wire bonding process. For example, the positive and/or negative electrodes of the photonic bare chip 110 are connected to the driver chip 120 through gold wire bonding, thereby reducing the parasitic inductance of the loop.

In some embodiments, the photonic bare chip 110 located on the circuit board 100 may be one or more pieces, and the invention does not impose any special restrictions thereon. For example, when packaging multiple photonic bare chips 110 directly to the circuit board 100, the multiple photonic bare chips 110 may be correspondingly arranged on the circuit board 100 and the electrical connection between the photonic bare chips 110 and the circuit board 100 may be completed. At this time, the packaging may be performed in the following two ways: first, a separate transparent insulating encapsulation colloid 130 is coated on a single photonic bare chip 110 to encapsulate it. Second, a single transparent insulating encapsulation colloid 130 is coated on multiple photonic bare chips 110 to encapsulate multiple photonic bare chips 110.

When the photonic bare chip 110 is packaged to the circuit board 100 by the transparent insulating encapsulation colloid 130, to ensure the reliability of the photonic bare chip 110, the transparent insulating encapsulation colloid 130 should be able to at least fully cover the photonic bare chip 110. On this basis, a reasonable selection can also be made according to the covering range of the transparent insulating encapsulation colloid 130, which will be further explained in conjunction with the accompanying drawings below.

In one embodiment, referring to FIG. 5, the transparent insulating encapsulation colloid 130 completely covers the photonic bare chip 110 and part of the bonding wire 150, so that the part where the bonding wire 150 is connected to the photonic bare chip 110 can be reinforced by the transparent insulating encapsulation colloid 130, thereby reducing the possibility of the bonding wire 150 falling off from the pad on the photonic bare chip 110, thereby improving the reliability and stability of the chip package.

In one embodiment, please refer to FIG. 6, the transparent insulating encapsulation colloid 130 completely covers the photonic bare chip 110 and the bonding wire 150. In other words, the bonding wire 150 is completely embedded in the transparent insulating encapsulation colloid 130. Thus, the bonding wire 150 can be reinforced by the transparent insulating encapsulation colloid 130, reducing the possibility of the bonding wire 150 falling off from the pad on the circuit board 100 or the photonic bare chip 110, thereby further improving the reliability and stability of the chip package. In addition, the packaged photonic bare chip 110 and the circuit board 100 as an integral module can well avoid touching the bonding wire 150 and causing the photonic bare chip 110 to fail in the back-end optical assembly process.

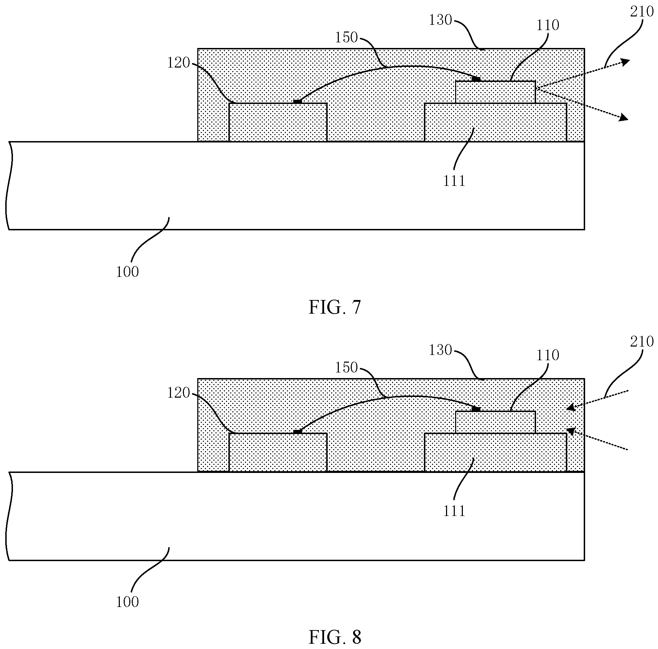

In one embodiment, referring to FIG. 7, the transparent insulating encapsulation colloid 130 completely covers the photonic bare chip 110, the bonding wires 150, and the driver chip 120. Thus, the transparent insulating encapsulation colloid 130 can be used to protect and seal the photonic bare chip 110, the bonding wires 150, and the driver chip 120, thereby improving the reliability and stability of the chip package.

In one embodiment, the transparent insulating encapsulation colloid 130 can also cover the entire circuit board 100, to cover the photonic bare chip 110, the bonding wires 150, the driver chip 120 and the various electronic components 140 on the circuit board 100, thereby improving the reliability and stability of the chip package.

Optionally, the photonic bare chip 110 can be a laser bare chip or a photosensitive chip. For example, when the photonic bare chip 110 is a laser bare chip, it can be applied to a laser emitting module, please refer to Figure 7. The driving circuit on the circuit board 100 can drive the photonic bare chip 110 to emit an outward light beam 210. when the photonic bare chip 110 is a photosensitive chip, it can be applied to a photosensitive module, please refer to Figure 8. The driving circuit on the circuit board 100 can also drive the photonic bare chip 110 to be sensitive to the incident light beam 210.

Please refer to Figures 7 and 8. In order to reduce the influence of the transparent insulating encapsulation colloid 130 on the light beam 210, the outer wall surface of the transparent insulating encapsulation colloid 130 corresponding to the window of the photonic bare chip 110 can be set to a plane (the right side wall of the transparent insulating encapsulation colloid 130 in Figure 7 or Figure 8 is a plane), so that the light beam 210 is less affected when it is incident or emitted from the window, and can be transmitted smoothly and accurately.

To make the chip package have better optical performance, an optical shaping part can be provided on the outer wall surface of the transparent insulating encapsulation colloid 130 corresponding to the window. In other words, an optical shaping part is formed at the front end of the window of the photonic bare chip 110. In this way, when the light beam is emitted from the window, the light beam can be shaped, thereby improving the light output quality of the laser bare chip and further improving the optical performance of the chip package.

In one embodiment, the optical shaping portion may be made of the same material as the transparent insulating encapsulation colloid 130. In one embodiment, the optical shaping portion may also be made of a material that is inconsistent with the material of the transparent insulating encapsulation colloid 130, which is not limited in the invention.

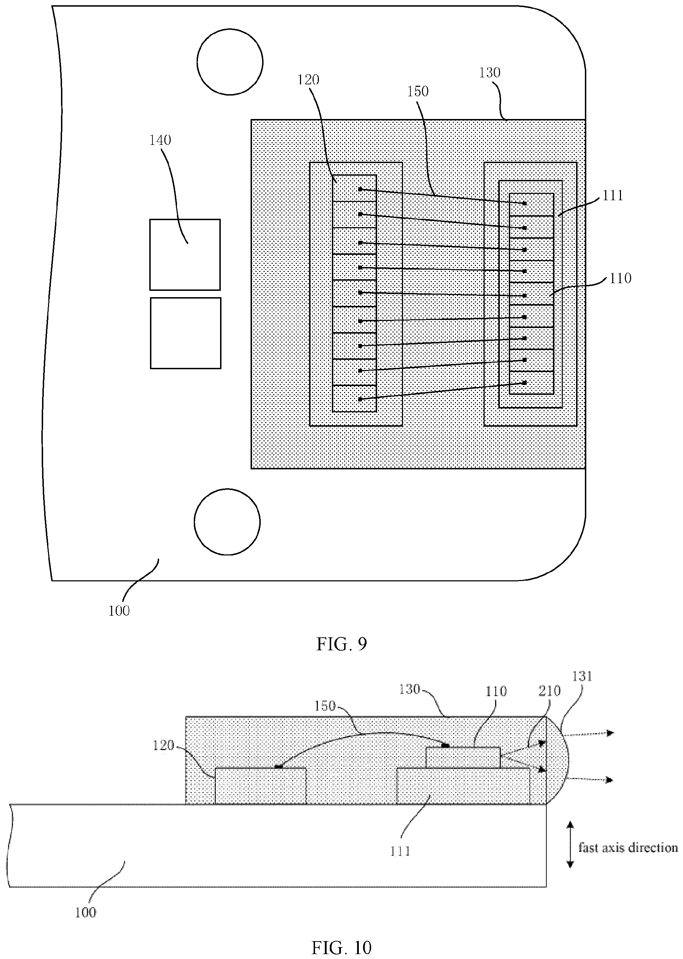

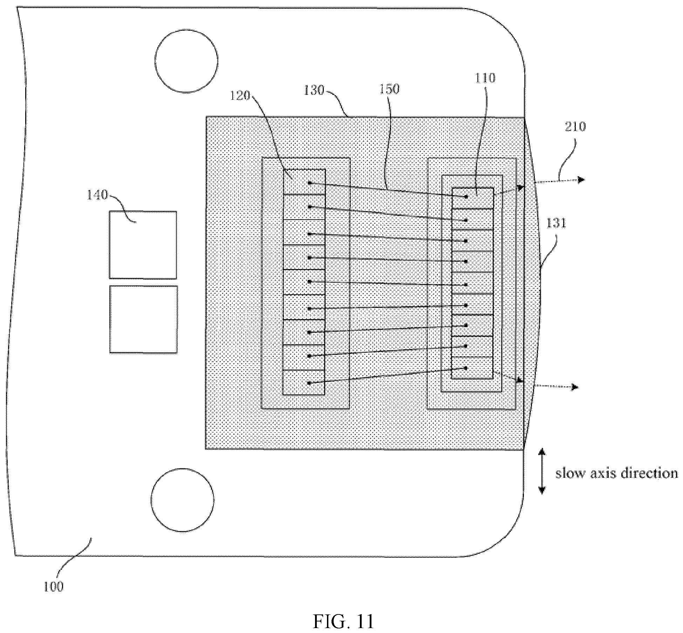

The optical shaping portion can be convex portion 131, which can pre-collimate the light beam emitted through the window, thereby reducing stray light, and improving optical performance. Please refer to Figures 10 and 11. The photonic bare chip 110 is a laser bare chip. When the photonic bare chip 110 is driven to emit a light beam 210, the light beam 210 can be collimated under the action of the convex portion 131 to improve the light output quality of the photonic bare chip 110.

In one embodiment, please refer to FIG. 10, which shows that the convex portion 131 pre-collimates the light beam 210 in the fast axis direction, that is, when the photonic bare chip 110 is driven to emit the light beam 210 through the window, the light beam 210 can be collimated in the fast axis direction when passing through the convex portion 131.

In one embodiment, please refer to FIG. 11, which shows that the convex portion 131 pre-collimates the light beam 210 in the slow axis direction, that is, when the photonic bare chip 110 is driven to emit the light beam 210 from the window, the light beam 210 can be collimated in the slow axis direction when passing through the convex portion 131.

In one embodiment, the convex portion 131 can pre-collimate the light beam 210 in both the fast axis direction and the slow axis direction. That is, when the photonic bare chip 110 is driven to emit the light beam 210 through the window, the light beam 210 can be collimated in both the fast axis direction and the slow axis direction when passing through the convex portion 131.

In one embodiment, the transparent insulating encapsulation colloid 130 is a high-temperature thermosetting colloid, that is, the transparent insulating encapsulation colloid 130 is a fluid at room temperature. When the photonic bare chip 110 is mounted on the circuit board, the transparent insulating encapsulation colloid 130 can be cured at high temperature during processes such as reflow soldering.

In one embodiment, the transparent insulating encapsulation colloid 130 is made of one of epoxy resin, silicone, and thermosetting plastic.

In one embodiment, the light transmittance of the transparent insulating encapsulant 130 is greater than 95%.

In another aspect of an embodiment of the invention, a photosensitive module is provided, comprising any one of the above-mentioned chip packages, wherein the photonic bare chip of the chip package is a photosensitive chip.

According to another aspect of the embodiments of the invention, a laser emitting module is provided, comprising any one of the above-mentioned chip packages, wherein the photonic bare chip of the chip package is a laser bare chip.

Another aspect of the embodiment of the invention provides lidar, comprising a processor and any of the above-mentioned chip packages, the processor is arranged on the circuit board 100 of the chip package, and the processor is connected to the circuit board 100 through a bonding wire, so that information interaction between the processor and the photonic bare chip 110 can be realized. Therefore, when the laser radar is mounted on a vehicle, a receiver that can interact with the processor can also be arranged on the circuit board 100, and the photonic bare chip 110 in the chip package can be used as a laser bare chip, and driven by the circuit board 100, the photonic bare chip 110 can be stimulated to emit a light beam toward the target object, and the light beam is reflected after reaching the target object and received by the receiver, and the processor determines the information of the target object according to the various parameter information of the light-emitting chip and the receiver. Among them, the target information can be information such as shape and distance, and the detection signal can be information such as the time and image of emission or reception.

The above description is only the preferred embodiment of the invention and is not intended to limit the invention. For those skilled in the art, the invention may have various modifications and variations. Any modification, equivalent replacement, improvement, etc. made within the spirit and principle of the invention shall be included in the protection scope of the invention.

## Claims

1. A chip package, **characterized in that** it comprises a circuit board and a photonic bare chip, wherein the photonic bare chip is arranged on the circuit board, and the photonic bare chip is connected to a drive circuit of the circuit board via bonding wires, so that the drive circuit can drive the photonic bare chip, and a transparent insulating encapsulation colloid, which at least covers the photonic bare chip, is also arranged on the circuit board, and the photonic bare chip has a window for light beam emission or incidence.

2. The chip package according to claim 1, **characterized in that** the transparent insulating encapsulation colloid at least covers the photonic bare chip and the bonding wire.

3. The chip package according to claim 1, **characterized in that** the driving circuit comprises a driver chip, and the photonic bare chip is connected to the driver chip via the bonding wire.

4. The chip package according to claim 3, **characterized in that** the transparent insulating encapsulation colloid at least covers the photonic bare chip, the bonding wires, and the driver chip.

5. The chip package according to claim 1, **characterized in that** the photonic bare chip is directly mounted on the circuit board, or the photonic bare chip is mounted on the circuit board via a substrate.

6. The chip package according to claim 1, **characterized in that** an outer wall surface of the transparent insulating encapsulation colloid corresponding to the window is a planer.

7. The chip package according to claim 1, **characterized in that** an optical shaping portion is provided on the outer wall surface of the transparent insulating encapsulation colloid corresponding to the window to shape the light beam emitted through the window.

8. The chip package according to claim 7, **characterized in that** the optical shaping portion is a convex portion, which is used to collimate the light beam emitted through the window along the fast axis and/or slow axis direction.

9. The chip package according to claim 1, **characterized in that** the light transmittance of the transparent insulating encapsulation colloid is greater than 95%.

10. The chip package according to claim 1, **characterized in that** the transparent insulating encapsulation colloid is set to one of epoxy resin, silicone and thermosetting plastic.

11. A photosensitive module, **characterized in that** it comprises a chip package according to any one of claims 1 to 6, wherein the photonic bare chip of the chip package is a photosensitive chip.

12. A laser emitting module, **characterized in that** it comprises a chip package according to any one of claims 1 to 10, wherein the photonic bare chip of the chip package is a laser bare chip.

13. A Lidar, **characterized in that** it comprises the laser emitting module according to claim 12.
